# EUROPEAN PATENT SPECIFICATION

(11) **EP 0 931 336 B1**
(45) Date of publication and mention of the grant of the patent: **29.07.2009**
(21) Application number: 97945131.7
(22) Date of filing: 25.09.1997
(51) Int. Cl.: H01L 21/331, H01L 21/20, H01L 29/73, H01L 29/24

(54) **A METHOD FOR PRODUCING A SILICON CARBIDE BIPOLAR DEVICE AND A SILICON CARBIDE BIPOLAR DEVICE**
VERFAHREN ZUR HERSTELLUNG VON EINER BIPOLAREN SILIZIUMKARBIDBAUELEMENT UND SILIZIUMKARBIDBAUELEMENT
PROCEDE DE PRODUCTION D'UN DISPOSITIF BIPOLAIRE DE CARBURE DE SILICIUM, ET UN TEL DISPOSITIF

(30) Priority: 14.10.1996 SE 9603738
(43) Date of publication of application: 28.07.1999
(73) Proprietor: CREE, INC., Durham, NC 27703 (US)
(72) Inventor: HERMANSSON, Willy, S-724 76 Västeras (SE)
(74) Representative: Olsson, Jan
(86) International application number: PCT/SE1997/001614
(87) International publication number: WO 1998/016951

(56) References cited:
- EP-A- 0 090 722
- EP-A- 0 430 237
- US-A- 3 988 772
- US-A- 4 752 818
- US-A- 5 061 972
- APPL. PHYS. LETT., Volume 62, No. 14, April 1993, J.T. BORENSTEIN et al., "Influence of Ion-Implanted Titanium on the Performance of Edge-Defined Film-Fed Grown Silicon Solar Cells", pages 1615-1616.

## Description

### TECHNICAL FIELD OF THE INVENTION AND PRIOR ART

The present invention relates to a method for producing a bipolar semiconductor device having a first layer doped according to a first doping type being one of a) n and b) p, said first layer being adapted to have minority charge carriers injected thereinto from a second layer of the device of an opposite doping type to that of the first layer in a forward conducting state of the device, said method comprising a step a) of epitaxially growing said first layer and a step b) of providing at least one region of said first layer with a constitution implying a lower lifetime of said minority charge carriers therein than in other parts of said first layer, said second layer being located next to said first layer, as well as a bipolar semiconductor device according to the preamble of the appended independent device claim.

The invention is occupied with all types of bipolar semiconductor devices, such as diodes, thyristors, BJTs and IGBTs, which have the common feature that minority charge carriers are injected into such a first layer, which normally is a low doped n-type drift layer, in the forward conducting state of the device resulting in an improved V(I)-characteristic of the device, i.e. the device requires a lower forward voltage for conducting a current of a certain value. However, it is also well known that the presence of these minority charge carriers in said first layer in the case of for instance a diode results in a reverse recovery of the device when it is turned off, i.e, switched into the reverse blocking state, which results in a reverse current in the reverse direction of the device during a certain period of time, the so called reverse recovery time, causing energy losses which may lead to cooling problems. In the case of a device of the type which is turned off like a GTO or an IGBT the presence of the minority charge carriers in said first layer results in a so called tail current in the forward direction upon turning off the device. This current also creates energy losses.

Accordingly, there is a trade-off between conduction on-state losses and switching or turn-off losses in such bipolar semiconductor devices, and the growth of said first layer is normally carried out so as to obtain highest possible lifetime for the minority charge carriers therein and by that the possibility to obtain so low conduction on-state losses as possible. It is known to use different techniques to after that reduce the lifetime of said minority charge carriers in said first layer or at least a region thereof for obtaining a faster recombination of the minority charge carriers when the device is turned off or switched in the reverse blocking state and by that lower switching losses, but this will at the same time, as mentioned, affect the plasma formed by the minority charge carriers in the forward conducting state of the device and by that cause an increase of the conduction on-state losses. However, these methods of lowering said lifetime have the advantage that the uniformity of said lifetime is increased with respect to the conditions prevailing in said first layer after the growth thereof

EP 0 090 722 only mentions that elements reducing the lifetime of minority charge carriers are introduced through diffusion (claim 3), which is also a useful technique for some materials, but not for SiC.

Furthermore, US-A-5 061 972 shows that it is known to grow doped layers of SiC by epitaxi.

It is known to introduce Au- or Pt-atoms into such a first layer of bipolar semicondutor devices of silicon by high temperature diffusion thereinto for creating recombination centres therein. However, this method is rather complicated to carry out and it is comparatively difficult to control the process and obtain a uniformity of the concentration of said atoms and by that a well defined minority charge carrier lifetime in said region of said first layer. This method has also a severe restriction, because it may only be used for materials in which the atoms to be introduced have a comparatively high diffusivity, so that it may for instance not be used for SiC-devices where the diffusitivity is very low.

It is also known to use electron irradiation as a means of minority charge carrier lifetime control, and this technology provides a clean and simple process with greater control and uniformity than can be achieved by the impurity diffusion process. The main disadvantage of this irradiation is that the radiation-induced recombination centres tend to anneal out after a period of time, not only but particularly when the device is subjected to high temperatures. This electron irradiation has hitherto been carried out, so that it has changed said lifetime homogeneously throughout the device thickness.

It is also known to use proton irradiation for causing damages of a restricted region of said first layer for obtaining a localised low lifetime region reducing the switching losses of bipolar devices but not lowering the conduction on-state losses that much. However, this proton irradiation has several disadvantages. It is difficult to obtain a homogenous influence of the whole region, in which said lifetime is to be lowered. Furthermore, it is associated with high costs to provide a source of proton irradiation. It is also difficult to reach regions located deeper into a device, especially in hard irradiation materials, such as SiC.

### SUMMARY OF THE INVENTION

The object of the present invention is to provide a method for producing a bipolar semiconductor device as defined in the introduction, which solves the problems adhered to the methods discussed above.

This object is according to the invention obtained by providing said method with the features mentioned in the characterising part of claim 1.

These features mean that a localized low lifetime region may be obtained without the need of any source of proton irradiation or the like simplifying the process considerably. Furthermore, it will be possible to obtain an excellent uniformity of the lifetime in said region if so desired. By growing said lower lifetime region in a part of the first layer located close to the second layer it is obtained that this region only increases the conduction on-state losses of the device so produced to a comparatively small extent, but the switching losses will be reduced considerably. This is due to a strongly enhanced recombination rate of minority charge carriers present in said first layer in said region when the device is turned off or switched to be reversed biased, which reduces the charge, i.e. the tail current, to flow until the steady state is reached in a device turned off and the charge which has to flow in the reversed direction after reverse biasing a device until the steady reversed blocking state is reached

According to another preferred embodiment of the invention the ratio of those of said substances that contain the basic elements for the growth of said first layer is changed dur-ing this growth when said region is grown. This is an easy and efficient way to influence the lifetime of said minority charge carriers in the region, and this will result in a lower quality of the region and by that a lower lifetime. "Basic elements" is defined as the elements participating in forming the basic structure of the material grown, so that they will in for instance the case of growing SiC be Si and C.

According to another preferred embodiment of the invention said region is formed by incorporating impurities during the growth of a certain thickness of said first layer, so that said region will be a sub-layer of the first layer having a lower lifetime of said minority charge carriers. A well defined such sub-layer having a lower minority charge carrier lifetime may so be simply realised by carrying out the method according to the invention.

According to another preferred embodiment of the invention said first layer is provided with a lifetime of said minority charge carriers varying throughout said first layer. It will in this way be possible to give different regions of said first layer exactly the minority charge carrier lifetime that is desired for each particular device and adapted for the later task of the device in question.

It is also an object of the present invention to provide a bipolar semiconductor device according to the appended independent device claim having a good trade-off between conduction on-state losses and switching losses with respect to such devices already known.

This object is according to the invention obtained by providing such a device according to appended claim 13.

Further advantages and preferred features of the invention will appear from the following description and the other dependent claims.

### BRIEF DESCRIPTION OF THE DRAWINGS

With reference to the appended drawings, below follows a specific description of a preferred embodiment of the invention cited as an example.

### In the drawings:

- Fig. 1: is a schematic cross-section view through a rectifying diode produced through a method according to the invention,
- Fig. 2: is a graph showing how the lifetime of minority charge carriers changes in the thickness direction of the diode in Fig. 1,
- Fig. 3: is a view of an electrical circuit in which the diode shown in Fig. 1 may be incorporated and for which simulations have been done for comparison with a circuit having a similar diode without any lower lifetime region in said first layer,
- Fig. 4: shows a graph of the current versus voltage in the forward conducting state of two diodes having different minority charge carrier lifetimes in the drift layer thereof,
- Fig. 5: shows a graph of the reverse recovery charge which has to flow in the reverse direction of a diode upon turning-off thereof versus the on-state forward voltage of a diode according to Fig. 1 and a corresponding diode having no lower lifetime region, and
- Fig. 6: shows a graph of the current through a diode versus time when it is turned-off for the diodes according to Fig. 5.

### DETAILED DESCRIPTION OF A PREFERRED EMBODIMENT OF THE INVENTION

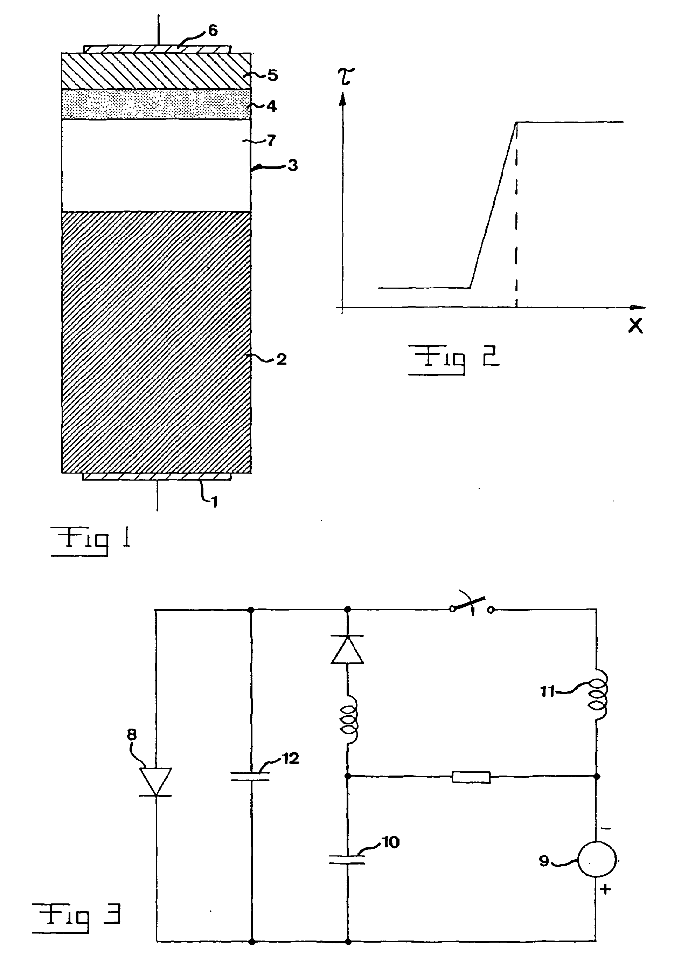

Fig. 1 illustrates a rectifying diode, to which the invention is applied. All semiconductor layers of this diode is made of SiC, and this diode and the features thereof will hereinafter be explained for illuminating the invention and the advantages thereof, since the invention is particularly advantageous in the SiC-case, but it is emphasised that the invention is not to be considered to be restricted to this semiconductor material. Fig. 1 is a very simplified view of the device, in which passivation layers and so on having nothing to do with the invention have been left out. The diode has superimposed a cathode 1, a comparatively thick highly doped n-type substrate layer 2, which here has a thickness of 50 µm and a doping concentration of 3x10¹⁸cm⁻³, a low doped n-type drift layer 3 having a total thickness of 30µm and a doping concentration of 2x10¹⁵cm⁻³, the uppermost region of which forming a sub-layer 4 having a lower lifetime of minority charge carriers than the rest of the drift layer and a thickness of 5µm, a highly doped p-type layer 5 having a thickness of 5µm and a doping concentration of 10¹⁹cm⁻³ and which forms a pn-junction with the drift layer, and finally an anode 6. In the forward conducting state of the diode the layer 5 will function as a hole emitter and inject minority charge carriers in the form of positive holes into the drift layer 3 forming a plasma therein and improving the conductivity of the device. However, this plasma does also give rise to energy losses when the diode is switched to be biased in the reverse direction.

The different layers 2-5 of this device are epitaxially grown by using the Chemical Vapour Deposition (CVD) technique or developments thereof, such as the High Temperature Chemical Vapour Deposition (HTCVD) technique and the first major part 7 of the drift layer 3 is grown with an aim to keep the minority charge carrier lifetime therein as high as possible, and the uppermost part 4 of the drift layer is epitaxially grown while introducing additives reducing said lifetime, so that these are incorporated in the layer 4 during the epitaxial growth thereof. Such impurities are in this case introduced to such a concentration that the minority charge carrier lifetime in the sub-layer 4 will be 10 ns, whereas the minority charge carrier lifetime will be 100 ns in said major part 7 of the drift layer. This is illustrated in Fig. 2, which illustrates said lifetime τ vs. the device thickness in said drift layer. Accordingly, the minority charge carrier lifetime is in this way varied in the axial direction of the device, so that the method according to the invention is here used to axially control the lifetime profile in the drift layer. The dashed line in Fig. 2 corresponds to the lower limitation of the sub-layer 4.

The impurities incorporated in said sub-layer 4 during the epitaxial growth thereof may be any type of element suitable to lower the lifetime of the minority charge carriers when present in the SiC-layer. Compensation may also be used for lowering the lifetime at a given doping concentration. For instance may N be incorporated at a concentration of 2x10¹⁵cm⁻³ and vanadium as compensating acceptor at a concentration of 10¹⁵cm⁻³ for obtaining a resulting doping concentration of n-type of 10¹⁵cm⁻³. Titanium is another good candidate for such a compensating acceptor in SiC.

Fig. 3 illustrates an electrical circuit, in which the SiC-diode 8 is built in, and the function of this switching circuit has been simulated by calculations and compared with the function thereof when the diode 8 is replaced by an identical diode except for the absence of said lower lifetime layer 4. This circuit is used to make a simple test of the diode turn-off in a circuit which gives a fairly good model of the situation as a free-wheeling diode in e.g. an IGBT converter. In the simulation the following circuit data was used: forward current 100A/cm², reverse DC voltage at 9 2,8 kV, clamped by the capacitance 10, di/dt for the commutation at turn-off 500A/cm²µs (controlled by the inductance 11) dV/dt during reverse blocking approximately 5kV/µs (adjusted by introducing the capacitance 12 into the circuit).

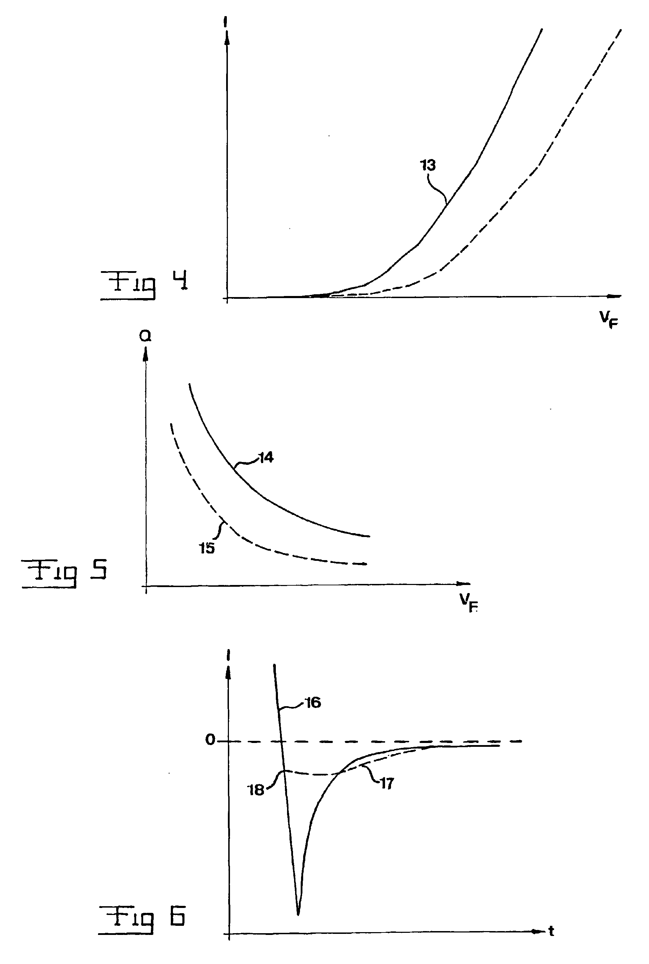

Before making comments upon the results of these simulations the influence of the minority charge carrier lifetime in the drift layer of a rectifier diode on the forward voltage at a given current through the diode in the forward conducting state thereof will be briefly discussed while referring to Fig. 4. The dashed line corresponds to a diode having a lower minority charge carrier lifetime in the drift layer than a corresponding diode, which then gets a V_{F}(I)-characteristic according to the line 13 in Fig. 4. Accordingly, a higher voltage has to be applied over a diode having a lower minority charge carrier lifetime in the drift layer thereof for obtaining a given current through the diode, which will then increase the on-state energy losses of the diode.

Fig. 5 illustrates how the charge Q to be led through the diode in the reverse direction upon turning-off thereof depends upon the forward voltage over the diode for a given current. The line 14 corresponds to a diode according to Fig. 1, but with an homogenous lifetime throughout the entire drift layer. Expressed in another way, it is illustrated how said charge is changed with the minority charge carrier lifetime in said drift layer, and travelling along the curve 14 from the top thereof and downwardly will mean going towards lower and lower minority charge carrier lifetimes and at the same time lower switching losses which have to be paid by increasing conduction on-state losses.

The simulations referred to above result in the dashed line 15 in Fig. 5 for the diode shown in Fig. 1. Accordingly, it will be possible to obtain a smaller charge to be led in said reverse direction upon turning-off the diode for a given forward voltage when a localised lower lifetime region is placed next to the p-emitter than when the lifetime has been lowered for the entire drift layer. Accordingly, a very good trade off between conduction on-state losses and switching losses may be obtained in this way.

The current I through a diode without the lower lifetime layer 4 (curve 16) and of the diode shown in Fig. 1 (curve 17) are illustrated in Fig. 6 as a function of the time elapsed after turning the diode off. It may be seen that the diode will reach the point 18 at which the pn-junction thereof will start to block at a much lower reverse current than in a diode having no such lower lifetime layer. It may also be seen that the total charge led through the diode in the reverse direction thereof after turning the diode off, and by that the turn-off energy loss, will be much lower for the diode according to the invention. A further important characteristic of the curve 17 is that a very "soft" reverse recovery is obtained, i.e. the reverse current is decreasing comparatively slowly, so that di/dt will be low and by that no high voltages will be created over a possible inductance of the switching circuit through which said current has to flow. It is true that the energy losses will be somewhat larger for such an extension of the curve 17 than if it would go faster towards zero from the point 18, but this will mostly be gratefully accepted, since the problems with a very large di/dt over an inductance may be avoided.

The invention is of course not in any way restricted to the preferred embodiment described above, but many possiblities to modifications thereof will be apparent to a man with ordinary skill in the art.

Although it has been shown in the figures how the minority charge carrier lifetime is varied in the axial direction of the device, it is within the scope of the invention to vary said lifetime in other directions by incorporating impurities during the epitaxial growth of said first layer, for instance by using the so called regrowth technique.

It would also be possible to incorporate different impurities in different parts of said first layer for obtaining different lifetimes in these different parts. The concentration of said impurities lowering said lifetime may also be varied so as to vary said lifetime throughout said first layer.

Said first layer may be doped according to the p-type as well as according to the n-type. In the first case electrons will form said minority charge carriers.

All definitions concerning the materials of the different device layers do of course also include inevitable impurities as well as intentional doping when SiC is concerned.

The definition layer is to be interpreted broadly and comprises all types of volume extensions and shapes.

Another technique of epitaxial growth than CVD, such as LPE, is also conceivable and within the scope of the present invention.

## Claims

1. A method of producing a bipolar semiconductor device having a first layer (3) consisting of a first sub-layer and a second sub-layer said first layer being doped according to a first doping type being one of a) n and b) p, said first layer being adapted to have minority charge carriers injected thereinto from a second layer (5) of the bipolar semiconductor device of an opposite doping type to that of the first layer in a forward conducting state of the device, said method comprising a step a) of epitaxially growing said first layer and a step b) of providing said second sub-layer of said first layer with a constitution implying a lower lifetime of said minority charge carriers therein than in other parts of said first layer, said second layer (5) being located next to said first layer (3), **characterized in that** at least said first layer is of SiC, that said second sub-layer (4) of said first layer is formed directly during the epitaxial growth of this region during step a) by incorporating impurities therein and by changing the composition of the substances including said impurities fed to said first layer for the growth thereof when said second sub-layer is grown and **in that** said second sub-layer (4) is grown between said first sub-layer and said second layer.

2. A method according to claim 1, wherein the ratio of those of said substances that contain the basic elements for the growth of said first layer (3) is changed during this growth when said region (4) is grown.

3. A method according to claim 2, wherein, the C/Si-ratio of said substances is changed during the growth of said first layer (3) when said region (4) is grown.

4. A method according to any of claims 1-3, wherein that at least said first layer is grown by Chemical Vapour Deposition (CVD).

5. method according to any of claims 1-4, wherein said second sub-layer (4) is a low doped drift layer of said bipolar semiconductor device.

6. A method according to any of claims 1-5, wherein said first layer (3) is grown as a n-type layer.

7. A method according to claim 6, wherein one of a) titanium and b) vanadium is incorporated as an impurity and a compensating acceptor in said second sub-layer (4) during the growth thereof for lowering said lifetime therein.

8. A method according to claim 5, wherein said first layer (3) is epitaxially grown with a very low doping concentration and with an aim to keep the minority charge carrier lifetime thereof as high as possible except from during the growth of a said second sub-layer.

9. A method according to any of claims 1-8, wherein said second sub-layer (4) is provided with a lifetime of said minority charge carriers being at least five times lower than in said first sub-layer (7).

10. A method according to any of claims 1-9, wherein said second sub-layer (4) is made thin with respect to the thickness of said first layer (3).

11. A method according to claim 10, wherein said second sub-layer (4) is made thinner than 1/3 of the thickness of said first layer (3).

12. A method according to any of claims 1-11, said impurities are strongly enhancing the recombination rate of said minority charge carriers.

13. A bipolar semiconductor device having a first layer (3) consisting of a first sub-layer and a second sub-layer, said first sub-layer being doped according to a first doping type being one of a) n and b) p, said first layer being adapted to have minority charge carriers injected thereinto from a second layer (5) of the bipolar semiconductor device of an opposite doping type to that of the first layer in a forward conducting state of the device, said second sub-layer (4) of said first layer having a constitution implying a lower lifetime of said minority charge carriers therein than said first sub-layer of said first layer said second layer (5) being located next to said first layer (3), **characterized in that** at least said first layer is of SiC, that said lower lifetime region of said first layer has impurities reducing said lifetime incorporated therein and another composition including said impurities than said second sub-layer of said first layer, said composition being obtained by an epitaxial growth of this region, and **in that** said second sub-layer (4) is grown between said first sub-layer (7) and said second layer.

## Patentansprüche

1. Verfahren zur Herstellung eines bipolaren Halbleiter-Bauelementes mit einer ersten Schicht (3), bestehend aus einer ersten Unterschicht und einer zweiten Unterschicht, wobei die erste Unterschicht gemäß einer ersten Dotierart entsprechend a) n und b) p, dotiert ist, die erste Schicht in der Lage ist, Minoritätsladungsträger aufzuweisen, die in sie aus einer zweiten Schicht (5) des bipolaren Halbleiter-Bauelementes mit einem dem Dotiertyp der ersten Schicht entgegengesetzten Dotiertyp injiziert wird, und zwar in einem Vorwärtsleitungszustand des Bauelements, wobei das Verfahren einen Schritt a) epitaxialen Wachsens der ersten Schicht sowie einen Schritt b) der Bildung der zweiten Unterschicht der ersten Schicht aufweist, und zwar mit einer Beschaffenheit, welche zu einer niedrigeren Lebensdauer der in ihr vorhandenen Minoritätsladungsträger führt als in anderen Teilen der ersten Schicht und wobei die zweite Schicht (5) direkt an der ersten Schicht (3) liegt, **dadurch gekennzeichnet, daß** wenigstens die erste Schicht SiC ist, daß die zweite Unterschicht (4) der ersten Schicht unmittelbar während des epitaxialen Wachstums dieses Bereiches während des Schritts a) gebildet wird, indem in sie Verunreinigungen eingebaut werden, und zwar **dadurch**, daß die Zusetzung der Substanzen, einschließlich der genannten Verunreinigungen, die der ersten Schicht zu derem Wachstum zugeführt werden, wenn die zweite Unterschicht wächst, und daß diese zweite Unterschicht (4) zwischen der ersten Unterschicht und der zweiten Schicht wächst.

2. Verfahren nach Anspruch 1, wobei das Verhältnis derjenigen Substanzen, die Grundelemente für das Wachstum der ersten Schicht (3) enthalten, während dieses Wachstums, wenn der Bereich (4) wächst, geändert wird.

3. Verfahren nach Anspruch 2, wobei das C / Si -Verhältnis der Substanzen während des Wachsens der ersten Schicht (3) geändert wird, wenn der Bereich (4) wächst.

4. Verfahren nach einem der Ansprüche 1 bis 3, wobei wenigstens die erste Schicht durch chemische Dampfablagerung (CVD) wächst.

5. Verfahren nach einem der Ansprüche 1 bis 4, wobei die zweite Unterschicht (4) eine gering dotierte Abweichungsschicht des bipolaren HalbleiterBauelements ist.

6. Verfahren nach einem der Ansprüche 1 bis 5, wobei die erste Schicht (3) als eine n-Typ-Schicht wächst.

7. Verfahren nach Anspruch 6, wobei entweder a) Titan oder b) Vanadium als ein Verunreinigungen kompensierender Akzeptor in die zweite Unterschicht (4) während dessen Wachsens zur Senkung der Lebensdauer in ihr eingebaut wird.

8. Verfahren nach Anspruch 5, wobei die erste Schicht (3) epitaxial wächst, und zwar mit einer sehr niedrigen Dotierkonzentration und mit dem Ziel, ihre Minoritätsladungsträger-Lebenszeit so lang wie möglich zu halten, ausgenommen während des Wachstums der zweiten Unterschicht.

9. Verfahren nach einem der Ansprüche 1 bis 8, wobei die zweite Unterschicht (4) mit einer Lebenszeit der Minoritätsladungsträger ausgestattet wird, die wenigstens fünfmal geringer ist als in der ersten Unterschicht (7).

10. Verfahren nach einem der Ansprüche 1 bis 9, wobei die zweite Unterschicht (4) in Bezug auf die Dicke der ersten Schicht (3) dünn ausgebildet wird.

11. Verfahren nach Anspruch 10, wobei die zweite Unterschicht (4) dünner gemacht wird als ein Drittel der Dicke der ersten Schicht (3).

12. Verfahren nach einem der Ansprüche 1 bis 11, wobei die Verunreinigungen die Rekombinationsgeschwindigkeit der Minderheitsladungsträger stark erhöhen.

13. Bipolares Halbleiter-Bauteil mit einer ersten Schicht (3), bestehend aus einer ersten Unterschicht und einer zweiten Unterschicht, wobei die erste Unterschicht gemäß einer ersten Dotierart a) n und b) p dotiert ist und wobei die erste Schicht so ausgebildet ist, daß sie mit Minderheits-Ladungsträger hat, die aus einer zweiten Schicht (5) des bipolaren Halbleiter-Bauteils eines zu dem Dotiertyp der ersten Schicht entgegengesetzten Dotiertyps in sie injiziert sind, und zwar in einem Vorwärtsleitungs-Zustand des Bauteils, wobei die zweite Unterschicht (4) der ersten Schicht eine Beschaffenheit aufweist, die den Minderheits-Ladungsträgern in ihr eine geringere Lebensdauer verleiht als die erste Unterschicht der ersten Schicht und wobei die zweite Schicht (5) der ersten Schicht (3) nächst benachbart ist, **dadurch gekennzeichnet, daß** wenigstens die erste Schicht aus SiC besteht, daß der Bereich geringerer Lebensdauer der ersten Schicht den ihr eingebauten die Lebensdauer reduzierenden Verunreinigungen eine andere Zusammensetzung, einschließlich der Verunreinigungen hat als die zweite Unterschicht der ersten Schicht, daß die Zusammensetzung ein epitaxiales Wachstum dieses Bereiches aufweist, und daß die zweite Unterschicht (4) zwischen der ersten Unterschicht und der zweiten Schicht gewachsen ist.

## Revendications

1. Procédé de production d'un dispositif semi-conducteur bipolaire ayant une première couche (3) constituée d'une première sous-couche et d'une seconde sous-couche, ladite première couche étant dopée selon un premier type de dopage qui est l'un de a) n et b) p, ladite première couche étant adaptée pour avoir des porteurs de charge minoritaires injectés dans celle-ci à partir d'une seconde couche (5) du dispositif semi-conducteur bipolaire d'un type de dopage opposé à celui de la première couche dans un état conducteur passant du dispositif, ledit procédé comprenant une étape a) de faire croître de façon épitaxiale ladite première couche et une étape b) de prévoir ladite seconde sous-couche de ladite première couche avec une composition impliquant une durée de vie inférieure desdits porteurs de charge dans celle-ci que dans d'autres parties de ladite première couche, ladite seconde couche (5) étant située près de ladite première couche (3),
**caractérisé en ce qu'**au moins ladite première couche est en SiC, **en ce que** ladite seconde sous-couche (4) de ladite première couche est formée directement durant la croissance épitaxiale de cette zone durant l'étape a) en incorporant des impuretés dans celle-ci et en changeant la composition des substances incluant lesdites impuretés amenées à ladite première couche pour la croissance de celle-ci lorsque ladite seconde sous-couche se développe, et **en ce que** ladite seconde sous-couche (4) se développe entre lesdites première sous-couche et seconde sous-couche.

2. Procédé selon la revendication 1, dans lequel le rapport de celles desdites substances qui contiennent les éléments basiques pour la croissance de ladite première couche (3) est changé durant cette croissance lorsque ladite zone (4) se développe.

3. Procédé selon la revendication 2, dans lequel le rapport C/Si desdites substances est changé durant la croissance de ladite première couche (3) lorsque ladite zone (4) se développe.

4. Procédé selon une quelconque des revendications 1-3, dans lequel au moins ladite première couche se développe par dépôt chimique en phase vapeur (CVD).

5. Procédé selon une quelconque des revendications 1-4, dans lequel ladite seconde sous-couche (4) est une couche de migration dopée faiblement dudit dispositif semi-conducteur bipolaire.

6. Procédé selon une quelconque des revendications 1-5, dans lequel ladite première couche (3) se développe comme une couche de type n.

7. Procédé selon la revendication 6, dans lequel l'un du a) titane et b) vanadium est incorporé comme une impureté et un accepteur de compensation dans ladite seconde sous-couche (4) durant sa croissance pour diminuer ladite durée de vie dans celle-ci.

8. Procédé selon la revendication 5, dans lequel ladite première couche (3) croît de façon épitaxiale avec une très faible concentration de dopage et avec le but de garder la durée de vie des porteurs de charge minoritaires de celle-ci aussi grande que possible excepté durant la croissance de ladite seconde sous-couche.

9. Procédé selon une quelconque des revendications 1-8, dans lequel ladite seconde sous-couche (4) est prévue avec une durée de vie desdits porteurs de charge minoritaires qui est au moins cinq fois inférieure que dans ladite première sous-couche (7).

10. Procédé selon une quelconque des revendications 1-9, dans lequel ladite seconde sous-couche (4) est rendue mince par rapport à l'épaisseur de ladite première couche (3).

11. Procédé selon la revendication 10, dans lequel ladite seconde sous-couche (4) est rendue plus mince qu'un tiers de l'épaisseur de ladite première couche (3).

12. Procédé selon une quelconque des revendications 1-11, dans lequel lesdites impuretés augmentent fortement la vitesse de recombinaison desdits porteurs de charge minoritaires.

13. Dispositif semi-conducteur bipolaire ayant une première couche (3) constituée d'une première sous-couche et d'une seconde sous-couche, ladite première sous-couche étant dopée selon un premier type de dopage qui est l'un de a) n et b) p, ladite première couche étant adaptée pour avoir des porteurs de charge minoritaires injectés dans celle-ci à partir d'une seconde couche (5) du dispositif semi-conducteur bipolaire d'un type de dopage opposé à celui de la première couche dans un état conducteur passant du dispositif, ladite seconde sous-couche (4) de ladite première couche ayant une constitution impliquant une durée de vie inférieure desdits porteurs de charge minoritaires dans celle-ci que dans ladite première sous-couche de ladite première couche, ladite seconde couche (5) étant située près de ladite première couche (3), **caractérisé en ce qu'**au moins ladite première couche est en SiC, **en ce que** ladite zone de durée de vie inférieure de ladite première couche a des impuretés réduisant ladite durée de vie incorporées dans celle-ci et une autre composition incluant lesdites impuretés que ladite seconde sous-couche de ladite première couche, ladite composition étant obtenue par croissance épitaxiale de cette zone, et **en ce que** ladite seconde sous-couche (4) se développe entre lesdites première sous-couche et seconde sous-couche.
